# EUROPÄISCHE PATENTANMELDUNG

(11) **EP 0 757 254 A2**
(43) Veröffentlichungstag der Anmeldung: **05.02.1997**
(21) Anmeldenummer: 96112378.3
(22) Anmeldetag: 31.07.1996
(51) Int. Cl.: G01R 31/316

(54) **Integrierte Schaltung**

(30) Priorität: 04.08.1995 DE 19528733
(71) Anmelder: SIEMENS AKTIENGESELLSCHAFT, 80333 München (DE)
(72) Erfinder: Michael, Ewald, Dipl.-Phys., 85540 Haar (DE)

(57) **Zusammenfassung**

Die integrierte Schaltung IC weist eine Schaltungsanordnung S auf, der ein Testsignal TEST zuführbar ist, das ein Ausgangssignal SOUT zur Folge hat, dessen Pegel oder dessen Verzögerung gegenüber dem Testsignal TEST innerhalb eines festlegbaren Toleranzbereiches liegen soll. Zur entsprechenden Überprüfung ist eine Prüfanordnung P vorgesehen. Auf diese Weise kann festgestellt werden, ob Fertigungseinflüsse eine Funktion der Schaltungsanordnung S negativ beeinflussen. Die Schaltungsanordnung S ist stellvertretend für gleichartige Schaltungsanordnungen derselben integrierten Schaltung IC testbar. Sie kann lediglich eine Schaltungskomponente aufweisen, beispielsweise einen Widerstand R, einen Kondensator, eine Spule usw. Sofern die Schaltungsanordnung S mit keiner sonstigen Schaltungskomponente verbunden ist, wird während ihrer Überprüfung die sonstige Funktion der integrierten Schaltung S nicht beeinflußt. Die Überprüfung kann dann durchgeführt werden, ohne daß ein spezieller Testbetriebsmodus notwendig ist. Insbesondere bei Überprüfung auf Waferebene kann ohne zusätzlichen Aufwand an Testzeit und Testapparaturen jede integrierte Schaltung IC separat überprüft werden.

## Beschreibung

Schaltungskomponenten integrierter Schaltungen weisen Kenngrößen auf, deren Wert abhängig von Schwankungen eines Herstellungsprozesses der integrierten Schaltung ist. Derartige Einflüsse des Herstellungsprozesses betreffen beispielsweise Materialzusammensetzungen, Dotierungskonzentrationen sowie Dicken, Breiten und Längen von herzustellenden Strukturen, die Bestandteile der Schaltungskomponenten sind. Die von diesen Einflüssen betroffenen Kenngrößen sind beispielsweise Widerstandswerte, Kapazitäten, Einsatzspannungen von Transistoren oder zeitliche Verzögerungen von Eingangssignalen durch die Schaltungskomponenten.

Es ist beispielsweise bekannt, bei der Herstellung von integrierten Schaltungen auf Wafer-Ebene eine Überprüfung von Widerstandswerten durchzuführen, um feststellen zu können, ob deren herstellungsbedingte Schwankungen innerhalb bestimmter Toleranzbereiche liegen. Dabei bedeutet eine Messung von Werten, die innerhalb des Toleranzbereiches liegen, daß die Prozeßschwankungen nicht so groß waren, die Funktionsfähigkeit der herzustellenden integrierten Schaltung negativ zu beeinflussen. Entsprechend muß der Toleranzbereich festgelegt werden. Die Durchführung der Überprüfung erfolgt dabei auf dem Wafer lediglich stichprobenartig bezüglich weniger auf dem Wafer befindlicher integrierter Schaltungen, wobei eine Prüfanordnung von außerhalb des Wafers über Meßpunkte den ausgewählten integrierten Schaltungen Testsignale zuführt und die resultierenden Ausgangssignale wieder empfängt. Anschließend findet außerhalb der integrierten Schaltung eine Auswertung der Ausgangssignale statt. Aus dem Ergebnis der Überprüfung wird dann ein Urteil bezüglich aller auf dem Wafer befindlicher integrierter Schaltungen gefällt, obwohl nur wenige von ihnen tatsächlich überprüft wurden. Es wird dann entschieden, ob der Wafer weiter verarbeitet oder aussortiert wird.

Dieses Vorgehen ist jedoch von Nachteil, da Prozeßschwankungen auch innerhalb eines Wafers auftreten können, weshalb eine Überprüfung jeder auf dem Wafer befindlichen integrierten Schaltung eine genauere Aussortierung ermöglichen würde. Eine derartige Überprüfung jeder integrierten Schaltung auf dem Wafer nach der beschriebenen Methode bedeutet jedoch einen sehr großen Aufwand: Zum einen wäre es dafür erforderlich, Meßpunkte auf jeder integrierten Schaltung mit entsprechenden Meßspitzen einer Prüfapparatur zu kontaktieren. Zum anderen wurde die Überprüfung jeder einzelnen integrierten Schaltung einen erheblichen zusätzlichen Zeitaufwand bei der Durchführung der Prüfprogramme bedeuten und/oder eine Aufstockung der Kapazität der verwendeten Prüfapparatur erfordern, was in beiden Fällen mit hohen zusätzlichen Kosten verbunden ist.

Der Erfindung liegt die Aufgabe zugrunde, eine integrierte Schaltung zu schaffen, bei der eine einfachere Überprüfung von Einflüssen eines Herstellungsprozesses auf Schaltungskomponenten, die Bestandteil der integrierten Schaltung sind, möglich ist und bei der die geschilderten Nachteile vermieden werden.

Diese Aufgabe wird durch eine integrierte Schaltung gemäß Anspruch 1 gelöst. Weiterbildungen der Erfindung sind in den Unteransprüchen gekennzeichnet.

Die Erfindung ermöglicht, statt einer einzelnen Schaltungskomponente auch wahlweise eine ganze Schaltungsanordnung, die mehrere Schaltungskomponenten aufweist, zu überprüfen. Der Einfluß der Fertigung auf die Funktion einer solchen Schaltungsanordnung resultiert aus den Einzeleinflüssen auf die darin enthaltenen Schaltungskomponenten.

Bei der erfindungsgemäßen integrierten Schaltung ist es möglich, einzelne Schaltungskomponenten oder Schaltungsanordnungen dadurch zu überprüfen, daß entsprechende Testsignale diesen zugeführt und resultierende Ausgangssignale durch eine Prüfanordnung auf der integrierten Schaltung ausgewertet werden. Hierzu ist, je nach Art der zu überprüfenden Kenngröße, der Pegel des Ausgangssignals oder seine zeitliche Verzögerung gegenüber dem Testsignal überprüfbar.

Das Testsignal kann der Schaltungsanordnung während eines Normalbetriebes oder während eines speziellen Testbetriebes zugeführt werden.

Im Gegensatz zum oben geschilderten Stand der Technik ist es mit der Erfindung möglich, Herstellungseinflüsse bei jeder integrierten Schaltung eines Wafers separat zu überprüfen, sofern jede integrierte Schaltung erfindungsgemäß ausgeführt ist. Eine Selektion der integrierten Schaltungen kann dann individuell, d. h. Schaltung für Schaltung, erfolgen.

Wird der Schaltungsanordnung das Testsignal zugeführt, ist sie aber ansonsten lediglich mit der Prüfanordnung und mit keiner weiteren Schaltungskomponente der integrierten Schaltung verbunden, die für eine Funktion der integrierten Schaltung vorgesehen ist, die nicht die erfindungsgemäße Überprüfung ist, so kann die integrierte Schaltung unabhängig von der erfindungsgemäßen Überprüfüng betrieben werden. Beispielsweise kann dann auf Waferebene gleichzeitig zu der erfindungsgemäßen Überprüfung ein Funktionstest der integrierten Schaltung durchgeführt werden. Eine spezielle Testbetriebsart ist nicht erforderlich. Hierdurch ergibt sich eine Zeitersparnis gegenüber dem Stand der Technik. Da die Prüfanordnung Bestandteil der integrierten Schaltung ist, muß für die erfindungsgemäße Überprüfung auch keine externe Prüfapparatur vorgesehen werden.

Das Ergebnis der Überprüfung ist beispielsweise an einen Anschluß der integrierten Schaltung übermittelbar oder kann mittels einer Deaktivierungseinrichtung zur Deaktivierung eines Ein- oder Ausganges der integrierten Schaltung verwendet werden. Im zuletzt geschilderten Fall ist das Ergebnis der Überprüfung besonders einfach feststellbar. Durch eine Deaktivierung des Ein- oder Ausganges, bei der dieser seine Funktion als Ein- oder Ausgang nicht mehr wahrnehmen kann (beispielsweise, indem er von mit ihm zuvor verbundenen Einheiten der integrierten Schaltung durch Öffnen eines Schalters abgetrennt wird), wird nämlich die Funktionsweise der integrierten Schaltung in besonders starkem Maße beeinträchtigt.

Es kann vorgesehen sein, daß die Prüfanordnung während jedes Betriebes der integrierten Schaltung eine Überprüfung der Schaltungsanordnung durchführt, so daß auch erst später auftretende Werte des Ausgangssignals außerhalb des Toleranzbereiches zu einer entsprechenden Anzeige durch das Ergebnissignal nach außerhalb der integrierten Schaltung führen.

Die Erfindung ermöglicht auch, daß die oben erwähnten, beim Stand der Technik zu findenden Überprüfungen auf Wafer-Ebene in der geschilderten Form entfallen können. Stattdessen ist für jede integrierte Schaltung auf dem Wafer das Ergebnis der Überprüfung während eines für gewöhnlich durchzuführenden Funktionstests der integrierten Schaltung ermittelbar, ohne daß dafür spezielle Prüfroutinen und die für deren Durchführung erforderlichen Prüfzeiten notwendig sind. Besonders günstig läßt sich dies erreichen durch die bereits erwähnte Deaktivierung eines Ein- oder Ausganges der integrierten Schaltung durch das Ergebnissignal mittels der Deaktivierungseinrichtung, da eine Deaktivierung eines Ein- oder Ausganges durch einen ohnehin oftmals durchzuführenden Funktionstest sehr schnell feststellbar ist.

Es ist ausreichend, wenn auf einer integrierten Schaltung nur je eine Schaltungskomponente derselben Art (beispielsweise je ein Widerstand, Kondensator, Spule und/oder Transistor) mit einer erfindungsgemäßen Prüfanordnung versehen ist. Diese sind dann stellvertretend für alle gleichartigen Schaltungskomponenten überprüfbar.

Weist die Schaltungsanordnung mehrere Schaltungskomponenten auf, ermöglicht die Erfindung, ein Ausgangssignal dieser Schaltungsanordnung zu überprüfen, das normalerweise von außerhalb der integrierten Schaltung nicht oder nur während eines spezifischen Testbetriebes zugänglich ist. Besonders vorteilhaft ist dies bei komplizierten Schaltungsketten, die aus einer Reihenschaltung mehrerer Schaltungsanordnungen bestehen.

Vor allem Schaltungsanordnungen, deren Funktion in besonders starkem Maße vom Herstellungsprozeß beeinflußt werden, deren Funktion aber nicht ohne weiteres von außerhalb der integrierten Schaltung überprüfbar ist, sollten mit der erfindungsgemäßen Prüfanordnung versehen werden.

Es ist vorsehbar, daß die Prüfanordnung aktivierbar und deaktivierbar ist. Dies kann beispielsweise durch Versetzen in eine Testbetriebsart bzw. eine Normalbetriebsart in bekannter Weise geschehen. Es ist auch möglich, trennbare bzw. schließbare Verbindungen (Transistoren oder Fuses bzw. Antifuses) vorzusehen, mittels derer eine Aktivierung oder eine Deaktivierung der Prüfanordnung erfolgt.

Die Erfindung wird im folgenden anhand der Zeichnung naher erläutert. Es zeigen:
- Figuren 1 und 2: Ausführungsbeispiele der erfindungsgemäßen integrierten Schaltung,
- Figur 3: ein Ausführungsbeispiel einer erfindungsgemäßen Prüfanordnung,
- Figur 4: in Figur 3 auftretende Signalverläufe.

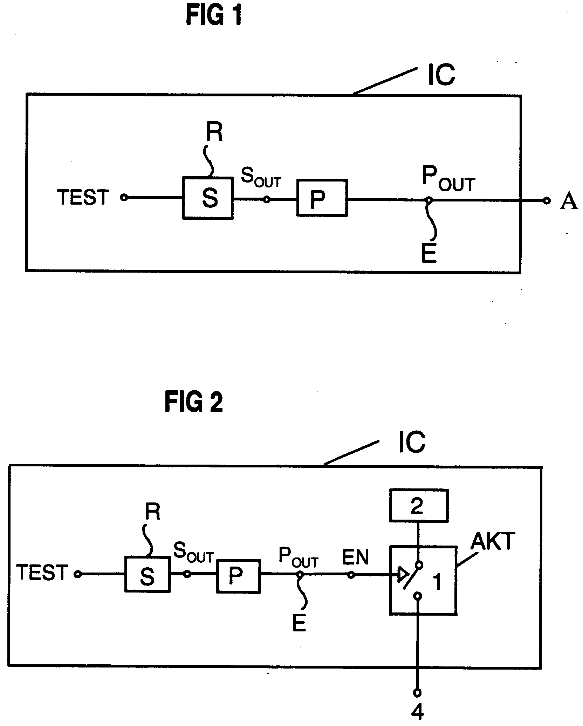

Figur 1 zeigt eine integrierte Schaltung IC, welche eine Schaltungsanordnung S und eine damit verbundene Prüfanordnung P aufweist. Die Schaltungsanordnung S weist eine Kenngröße auf, deren Wert abhängig von Schwankungen eines Herstellungsprozesses der integrierten Schaltung IC ist. An die Schaltungsanordnung S ist ein Testsignal TEST anlegbar, welches ein Ausgangssignal SOUT zur Folge hat, das der Prüfanordnung P zuführbar ist. Mittels der Prüfanordnung P ist überprüfbar, ob der Pegel des Ausgangssignals SOUT oder dessen zeitliche Verzögerung gegenüber dem Testsignal TEST innerhalb eines Toleranzbereiches liegt. Der Toleranzbereich ist so festlegbar, daß für Pegel bzw. zeitliche Verzögerungen des Ausgangssignals SOUT, die außerhalb des Toleranzbereiches liegen, die Schaltungsanordnung S die Funktionsfähigkeit der integrierten Schaltung IC nicht mehr sicher gewahrleistet. Die integrierte Schaltung IC sollte dann nicht weiter verwendet werden.

Die Festlegung derartiger Toleranzbereiche stellt für den Fachmann kein Problem dar, da sie durch sogenannte Spezifikationen oder durch Timing-Diagramme für jede integrierte Schaltung IC für gewohnlich definiert werden.

Ein Ausgang POUT der Prüfanordnung P ist mit einem Anschlußpin oder Anschlußpad A der integrierten Schaltung IC verbunden. Am Ausgang POUT ist durch die Prüfanordnung P ein Ergebnissignal E erzeugbar, mittels dessen das Ergebnis der Überprüfung nach außerhalb der integrierten Schaltung IC übermittelbar ist. Das Ergebnissignal E kann beispielsweise zwei Pegel aufweisen, wobei es den einen Pegel annimmt, wenn der Pegel bzw. die zeitliche Verzögerung des Ausgangssignals SOUT innerhalb des Toleranzbereiches liegt, und wobei es den anderen Pegel im anderen Fall annimmt.

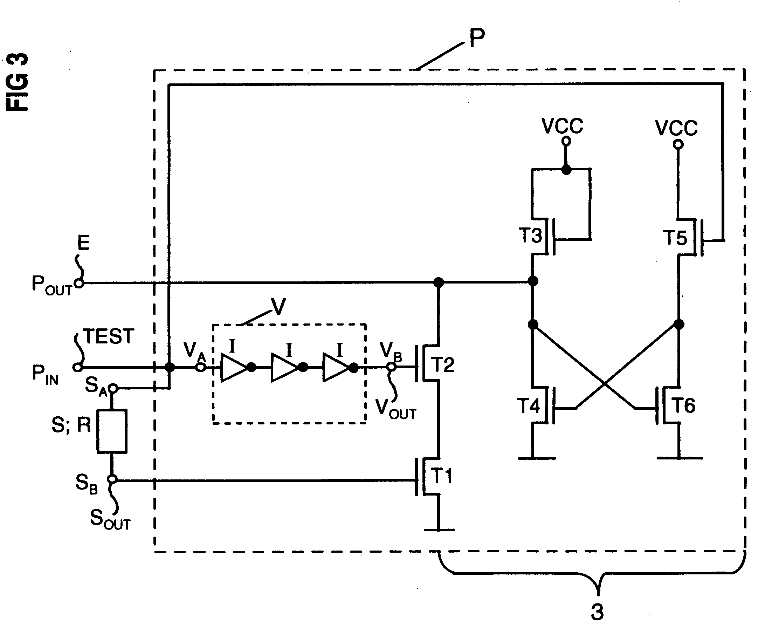

Ein konkretes Ausführungsbeispiel für die Schaltungsanordnung S und die Prüfanordnung P wird weiter unten anhand der Figur 3 dargestellt.

Figur 2 zeigt in Abwandlung von Figur 1 ein Ausführungsbeispiel der Erfindung, bei dem der Ausgang POUT des Prüfmittels P mit einem Aktivierungseingang EN einer Deaktivierungseinrichtung AKT verbunden ist. Über das auf diese Weise am Aktivierungseingang EN anliegende Ergebnissignal E ist die Deaktivierungseinrichtung AKT in einen aktivierten und einen deaktivierten Zustand versetzbar. Sie weist einen Schalter 1 auf, welcher in ihrem deaktivierten Zustand geschlossen ist und der zwischen einem Ein- oder Ausgang 4 der integrierten Schaltung IC und Einheiten 2 der integrierten Schaltung IC angeordnet ist, denen dieser als Ein- oder Ausgang dient. Befindet sich die Deaktivierungseinrichtung AKT im aktivierten Zustand, ist der Schalter 1 geöffnet, so daß der Ein- oder Ausgang 4 von den Einheiten 2 trennbar ist.

Bei diesem Ausführungsbeispiel der Erfindung wird bei Anzeige eines negativen Ergebnisses der Überprüfung durch das Ergebnissignal E der Ein- oder Ausgang 4 von der Deaktivierungseinrichtung AKT deaktiviert. Handelt es sich bei dem Ein- oder Ausgang 4 um einen Eingang, ist es dann nicht möglich, Eingangssignale über diesen an die Einheiten 2 zu übermitteln. Ist der Ein- oder Ausgang 4 ein Ausgang, können an ihm dann keine Ausgangssignale der Einheiten 2 empfangen werden. In beiden Fällen wird die Funktion der integrierten Schaltung IC in besonders starkem Maße durch das Ergebnissignal E beeinflußt, wenn das Ergebnis der Überprüfung negativ ausgefallen ist, das heißt, der Pegel bzw. die zeitliche Verzögerung des Ausgangssignals SOUT außerhalb des Toleranzbereiches liegt. Das Ergebnis der Überprüfung ist dann von außerhalb der integrierten Schaltung IC besonders leicht feststellbar. Die integrierte Schaltung IC sollte bei negativem Ergebnis der Überprüfung nicht weiter eingesetzt werden.

Der Anschluß A in Figur 1 und der Ein- oder Ausgang 4 in Figur 2 können im Falle einer gehäuselosen integrierten Schaltung IC Anschlußpads und im Falle einer integrierten Schaltung IC mit Gehäuse Anschlußpins sein.

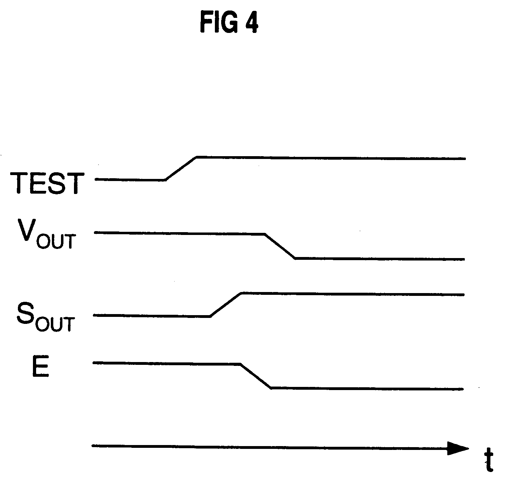

Anhand Figur 3 wird nun ein konkretes Ausführungsbeispiel für die Prüfanordnung P und die Schaltungsanordnung S geschildert. Die abgebildete Schaltungsanordnung S enthalt nur eine Schaltungskomponente in Form eines Widerstandes R. Dieser hat einen ersten Anschluß SA und einen zweiten Anschluß SB. Sein ohmscher Widerstand (d.h. seine Kenngröße) ist abhängig von Herstellungseinflüssen. Die Prüfanordnung P weist eine Referenzanordnung V auf, welche bei diesem Ausführungsbeispiel eine Verzögerungsschaltung ist, die drei Inverter I enthält. Die Verzögerungsschaltung weist einen Eingang VA und einen Ausgang VB auf. Dem Eingang VA der Verzögerungsschaltung und dem ersten Anschluß SA des Widerstandes R, die miteinander verbunden sind, ist über einen Eingang PIN der Prüfanordnung P das Testsignal TEST zuführbar, welches gemäß Figur 4 einen Pegelwechsel aufweist.

Zusätzlich weist die Prüfanordnung P weitere Elemente 3 auf, mit denen ein Vergleich eines Ausgangssignals VOUT am Ausgang VB der Verzögerungsschaltung mit einem Ausgangssignal SOUT am zweiten Anschluß SB des Widerstandes durchführbar ist. Hierzu ist der zweite Anschluß SB des Widerstandes R mit dem Gate eines ersten n-Kanal-Transistors T1 und der Ausgang VB der Verzögerungsschaltung mit dem Gate eines zweiten n-Kanal-Transistors T2 verbunden. Der zweite T2 und der erste T1 Transistor sind zwischen dem Ausgang POUT der Prüfanordnung P und einem ersten Versorgungspotential Masse der integrierten Schaltung IC angeordnet. Zwischen einem zweiten Versorgungspotential VCC der integrierten Schaltung IC und dem ersten Versorgungspotential Masse sind ein dritter n-Kanal-Transistor T3, welcher als Diode geschaltet ist, und ein vierter n-Kanal-Transistor T4 sowie parallel dazu ein fünfter n-Kanal-Transistor T5 und ein sechster n-Kanal-Transistor T6 angeordnet. Die Drain des vierten Transistors T4 und das Gate des sechsten Transistors T6 sowie die Drain des sechsten Transistors T6 und das Gate des vierten Transistors T4 sind jeweils miteinander verbunden. Außerdem ist die Drain des vierten Transistors T4 mit dem Ausgang POUT des Prüfmittels P verbunden. Der Eingang VA der Verzögerungsschaltung ist mit dem Gate des fünften Transistors T5 verbunden.

Die Funktion des in Figur 3 dargestellten Ausführungsbeispiels der Prüfanordnung P wird nun anhand der in Figur 4 dargestellten Signalverläufe erläutert: Die zeitliche Verzögerung eines Pegelwechsels des Testsignals TEST durch die Verzögerungsschaltung ist so dimensioniert, daß sie einer oberen Grenze des Toleranzbereiches für die Verzögerung durch den Widerstand R entspricht. Die Verzögerung durch den Widerstand R ist jedoch abhängig von dessen ohmschem Widerstand. In Figur 4 ist der Fall dargestellt, daß die Verzögerung durch die Schaltungskomponente S kleiner ist als durch die Verzögerungsschaltung. Daher kommt der Pegelwechsel des Ausgangssignals SOUT der Schaltungskomponente S früher als derjenige des Ausgangssignals VOUT der Verzögerungsschaltung.

Gemaß Figur 3 wird über den dritten Transistor T3 das Ergebnissignal E am Ausgang POUT der Prüfanordnung P solange auf dem Wert des zweiten Versorgungspotentials VCC gehalten, bis der erste Transistor T1 öffnet, bevor der zweite Transistor T2 schließt. Nur in diesem Fall ergibt sich für das Ergebnissignal E ein Pegelwechsel auf den Wert des ersten Versorgungspotentials Masse. Das Flip-Flop, welches aus den dritten bis sechsten Transistoren T3 bis T6 gebildet wird, sorgt dafür, daß der jeweilige Pegel des Ergebnissignals E gehalten wird.

Wurde die Schaltungskomponente S in Figur 3 einen zu großen ohmschen Widerstand aufweisen, der eine Verzögerung außerhalb des zuvor festgelegten Toleranzbereiches aufweist, käme der Pegelwechsel beim Ausgangssignal SOUT der Schaltungskomponente S später als derjenige beim Ausgangssignal VOUT der Verzögerungsschaltung. Es käme dann nicht zu einem Pegelwechsel beim Ergebnissignal E, welches stattdessen auf dem Wert des zweiten Versorgungspotentials VCC bleiben würde.

Das Testsignal TEST kann beispielsweise ein Taktsignal der integrierten Schaltung IC sein. Es ist jedoch beim zuletzt geschilderten Ausführungsbeispiel auch möglich, jedes andere Signal, welches einen Pegelwechsel aufweist, zu verwenden.

Beim Ausführungsbeispiel nach Figur 3 ist die Schaltungsanordnung S nur mit der Prüfanordnung P, jedoch mit keiner weiteren Schaltungskomponente der integrierten Schaltung IC verbunden. Eine solche Schaltungsanordnung S kann nicht zur Erfüllung anderer Funktionen als der erfindungsgemäßen Überprüfung dienen. Sie kann zusätzlich zu gleichartigen Schaltungsanordnungen Bestandteil derselben integrierten Schaltung IC sein. Sehr vorteilhaft ist dann, daß sie stellvertretend für die gleichartigen Schaltungsanordnungen (beim Ausführungsbeispiel in Figur 3 wären dies ebenfalls einzelne Widerstände) überprüfbar ist und daß das Ergebnis der Überprüfung zur Bewertung der Funktionsfähigkeit der gesamten integrierten Schaltung IC dient. Auf diese Weise wird eine Beeinflussung der normalen Funktion der integrierten Schaltung IC durch die Überprüfung vermieden.

Beispielsweise kann je ein Widerstand R, ein Kondensator, ein Transistor usw. als je eine Schaltungsanordnung S mit entsprechender Prüfanordnung P auf einer integrierten Schaltung IC vorgesehen sein.

## Patentansprüche

1. Integrierte Schaltung mit folgenden Merkmalen:
- Sie enthalt eine Schaltungsanordnung (S), der ein Testsignal (TEST) zuführbar ist, als Folge dessen sich ein Ausgangssignal (SOUT) einstellt,
- die integrierte Schaltung (IC) weist eine Prüfanordnung (P) auf, mit der überprüfbar ist, ob das Ausgangssignal (SOUT) innerhalb eines gegebenen Toleranzbereiches liegt,
- die Prüfanordnung (P) weist einen Ausgang (POUT) auf, an welchem sie bei Durchführung der Überprüfung ein entsprechendes Ergebnissignal (E) erzeugt,
- das Ergebnissignal (E) ist nach außerhalb der integrierten Schaltung (IC) übermittelbar.

2. Integrierte Schaltung nach Anspruch 1,
**dadurch gekennzeichnet,**
daß mit der Prüfanordnung (P) überprüfbar ist, ob der Pegel des Ausgangssignals (SOUT) innerhalb des Toleranzbereiches liegt.

3. Integrierte Schaltung nach Anspruch 1,
**dadurch gekennzeichnet,**
daß mit der Prüfanordnung (P) überprüfbar ist, ob die zeitliche Verzögerung des Ausgangssignals (SOUT) gegenüber dem Testsignal (TEST) innerhalb des Toleranzbereiches liegt.

4. Integrierte Schaltung nach einem der vorstehenden Ansprüche,
**dadurch gekennzeichnet,**
daß die Schaltungsanordnung (S) nur eine Schaltungskomponente enthält.

5. Integrierte Schaltung nach einem der vorstehenden Ansprüche,
**dadurch gekennzeichnet,**
daß die Schaltungsanordnung (S) außer mit der Prüfanordnung (P) und außer mit einem Anschluß, über den ihr das Testsignal (TEST) zuführbar ist, mit keiner weiteren Schaltungskomponente der integrierten Schaltung (IC) verbunden ist.

6. Integrierte Schaltung nach einem der vorstehenden Ansprüche,
**dadurch gekennzeichnet,**
daß die Prüfanordnung (P) eine Referenzanordnung (V) aufweist, der das Testsignal (TEST) ebenfalls zuführbar ist, daß sich als Folge dessen ein Ausgangssignal (VOUT) der Referenzanordnung (V) einstellt, das gleich dem Ausgangssignal (SOUT) der Schaltungsanordnung (S) ist, sofern dessen Pegel bzw. dessen zeitliche Verzögerung gegenüber dem Testsignal (TEST) an einer Grenze des Toleranzbereiches liegt,
und daß die Prüfanordnung (P) weitere Elemente (3) aufweist, mit denen die Pegel der Ausgangssignale (VOUT, SOUT) der Referenzanordnung (V) und der Schaltungsanordnung (S) bzw. ihre zeitlichen Verzögerungen gegenüber dem Testsignal (TEST) miteinander vergleichbar sind.

7. Integrierte Schaltung nach Anspruch 6,
**dadurch gekennzeichnet,**
daß die Referenzanordnung (V) eine Verzögerungsschaltung ist, daß das Testsignal (TEST) einen Pegelwechsel aufweist und daß mit den weiteren Elementen (3) die zeitliche Reihenfolge von Pegelwechseln der Ausgangssignale (VOUT, SOUT) der Referenzschaltung (V) und der Schaltungsanordnung (S) feststellbar ist.

8. Integrierte Schaltung nach Anspruch 7,
**dadurch gekennzeichnet,**
daß die Verzögerungsschaltung eine Reihenschaltung logischer Gatter (I) aufweist.

9. Integrierte Schaltung nach einem der vorstehenden Ansprüche,
**dadurch gekennzeichnet,**
daß das Testsignal (TEST) ein Taktsignal der integrierten Schaltung (IC) ist.

10. Integrierte Schaltung nach einem der vorstehenden Ansprüche,
**dadurch gekennzeichnet,**
daß der Ausgang (POUT) der Prüfanordnung (P) mit einem Anschlußpin oder Anschlußpad (A) der integrierten Schaltung (IC) verbunden ist.

11. Integrierte Schaltung nach einem der Ansprüche 1 bis 9,
**dadurch gekennzeichnet,**
daß der Ausgang (POUT) der Prüfanordnung (P) mit einem Aktivierungseingang (EN) einer Deaktivierungseinrichtung (AKT) verbunden ist,
daß die Deaktivierungseinrichtung (AKT) durch das Ergebnissignal (E) im Falle, daß der Pegel bzw. die zeitliche Verzögerung des Ausgangssignals (SOUT) der Schaltungsanordnung (S) außerhalb des Toleranzbereiches liegt, in einen aktivierten Zustand und ansonsten in einen deaktivierten Zustand versetzbar ist,
daß die Deaktivierungseinrichtung (AKT) mit einem Ein- oder Ausgang (4) der integrierten Schaltung (IC) verbunden ist, der ein Anschlußpin oder Anschlußpad ist,
und daß der Ein- oder Ausgang (4) durch Versetzen der Deaktivierungseinrichtung (AKT) in den aktivierten Zustand deaktivierbar ist, so daß die Ausübung seiner Funktion als Ein- oder Ausgang unterbunden ist, während er im deaktivierten Zustand der Deaktivierungseinrichtung (AKT) von ihr unbeeinflußt ist.

12. Integrierte Schaltung nach einem der vorherstehenden Ansprüche,
**dadurch gekennzeichnet,**
daß die Prüfanordnung (P) aktivierbar und deaktivierbar ist.
